# EUROPEAN PATENT SPECIFICATION

(11) **EP 2 685 630 B1**
(45) Date of publication and mention of the grant of the patent: **22.10.2014**
(21) Application number: 12176475.7
(22) Date of filing: 13.07.2012
(51) Int. Cl.: H03F 1/02, H03F 3/45

(54) **A two stage single-ended input, differential output current reuse low noise amplifier**
Zweistufiger rauscharmer Verstärker mit Eintakteingang und Differenzausgangsstromwiederverwendung
Entrée à extrémité unique à deux étages, réutilisation du courant de sortie différentielle de l'amplificateur à faible bruit

(43) Date of publication of application: 15.01.2014
(73) Proprietor: CSEM Centre Suisse d'Electronique et de Microtechnique SA, 2002 Neuchâtel (CH)
(72) Inventor: Pengg, Franz Xaver, 1205 Genève (CH)
(74) Representative: P&TS SA (AG, Ltd.)

(56) References cited:
- EP-A1- 2 037 572
- EP-A2- 1 816 742
- US-A1- 2002 084 855
- US-A1- 2010 019 848
- INUI C ET AL: "60GHz CMOS Current-Reuse Cascade Amplifier", MICROWAVE CONFERENCE, 2007. APMC 2007. ASIA-PACIFIC, IEEE, PISCATAWAY, NJ, USA, 11 December 2007 (2007-12-11), pages 1-4, XP031280103, ISBN: 978-1-4244-0748-4
- VITTORIO GIAMMELLO ET AL: "A Transformer-Coupling Current-Reuse SiGe HBT Power Amplifier for 77-GHz Automotive Radar", IEEE TRANSACTIONS ON MICROWAVE THEORY AND TECHNIQUES, IEEE SERVICE CENTER, PISCATAWAY, NJ, US, vol. 60, no. 6, 1 June 2012 (2012-06-01), pages 1676-1683, XP011445272, ISSN: 0018-9480, DOI: 10.1109/TMTT.2012.2189243
- SIROOS TOOFAN ET AL: "A 5.5-GHz 3mW LNA and inductive degenerative CMOS LNA noise figure calculation", MICROELECTRONICS, 2008. ICM 2008. INTERNATIONAL CONFERENCE ON, IEEE, PISCATAWAY, NJ, USA, 14 December 2008 (2008-12-14), pages 308-312, XP031615487, ISBN: 978-1-4244-2369-9
- HSIEH-HUNG HSIEH ET AL: "Design of Ultra-Low-Voltage RF Frontends With Complementary Current-Reused Architectures", IEEE TRANSACTIONS ON MICROWAVE THEORY AND TECHNIQUES, IEEE SERVICE CENTER, PISCATAWAY, NJ, US, vol. 49, no. 7, 1 July 2007 (2007-07-01), pages 1445-1458, XP011187189, ISSN: 0018-9480, DOI: 10.1109/TMTT.2007.900208
- GRAMEGNA G ET AL: "An 8.2-ghz, 14.4mw, 1.6db nf sige bipolar lna with dc current reuse", PROCEEDINGS OF THE 2003 BIPOLAR/BICMOS CIRCUITS AND TECHNOLOGY MEETING. ( BCTM ). TOULOUSE, FRANCE, SEPT. 28 - 30, 2003; [IEEE BIPOLAR/BICMOS CIRCUITS AND TECHNOLOGY MEETING], NEW YORK, NY : IEEE, US, 28 September 2003 (2003-09-28), pages 49-52, XP010688453, DOI: 10.1109/BIPOL.2003.1274933 ISBN: 978-0-7803-7800-1
- PENG WANG ET AL: "A novel low-power fully-differential current-reuse cascaded CG-CS-LNA for 6â 9-GHz UWB receivers", ELECTRONICS, CIRCUITS, AND SYSTEMS (ICECS), 2010 17TH IEEE INTERNATIONAL CONFERENCE ON, IEEE, 12 December 2010 (2010-12-12), pages 1188-1191, XP031923168, DOI: 10.1109/ICECS.2010.5724730 ISBN: 978-1-4244-8155-2

## Description

### Field of the invention

The present invention concerns a current-reuse low noise amplifier and an integrated circuit comprising this amplifier.

### Description of related art

The design of the radio frequency (RF) front-end circuit is nowadays of primary importance for the good performance of a transceiver radio link. In this context the expression "radio-frequency" indicates the range of frequencies between 3 kHz and 300 GHz, in particular between 300 MHz and 6 GHz. The transceiver can for example be used as part of a wireless sensor node, a medical device (hearing aids, insulin pump control, pace-maker, etc), a device for a body area network (BAN), a high performance receiver for GPS applications, etc.

After the antenna receiving the RF signal, which is single-ended in most applications, there is sometimes a SAW (Surface Acoustic Wave) filter for attenuating the signals outside of the signal frequency band. After the SAW filter the first block of the receiver could be an amplifier, named low-noise amplifier or LNA. In fact the total noise of a receiver is mainly determined by the noise and gain of its first block, i.e. the LNA, the noise of the next blocks referred to the input of the receiver being proportionally less significant since reduced by the gain of the preceding blocks.

The LNA could be followed by a mixer for translating the frequency of the received signal from the RF frequency to a lower frequency, named intermediated frequency or IF. In the case of a direct conversion architecture of the receiver, the mixer translates the received signal in the base band.

The low noise amplifier could be a double-ended or differential amplifier. In this case, it amplifies the difference between two input voltages or currents. This solution in fact is commonly used since it allows the rejection of the common mode disturbances, and a better linearity of the second order, not only of the LNA but also of the overall receiving chain which in general handles differential signals.

The single-ended signal to differential signal conversion can be done in numerous ways, either by capacitive coupling or by magnetic coupling while assuring a phase shift of 180° between the original single-ended signal and the generated opposite signal.

A possible and simple implementation is to apply the single ended signal on one input of a differential amplifier while AC-coupling the opposite input to ground. It is also possible to couple two half differential amplifiers and use passive components to guarantee the symmetry.

Another commonly used possibility is a balun, comprising for example an inductive transformer, to generate the differential signals before applying them to the differential LNA. The balun is in general an external element, which is not integrated in the circuit comprising the receiving chain. It is in general placed between the SAW filter and the LNA, if the SAW filter has single ended input and output ports.

The use of an external balun implies supplementary losses and an additional interface to be designed for the low noise amplifier.

Implementing the balun as integrated element entails a degradation of the noise performance since losses are generated at the receiver input. Moreover its realization requires a substantial increase of layout-area.

Another possibility is to use a SAW filter which performs the single-ended to differential transformation at the same time as it performs the filtering.

The low noise amplifier could have a current reuse topology with two stages. The expression "current reuse" means that the first and second gain stages are stacked such that the same DC current between the supply rails Vsupply and ground is used for both of them.

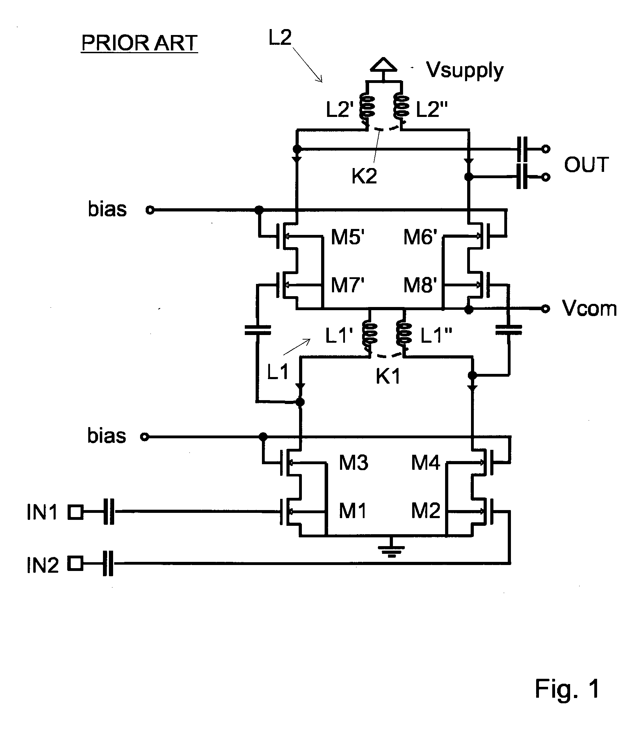

An embodiment of this kind of amplifier is shown in Figure 1. In this implementation a first amplifying or gain stage, comprising the transistors M1 to M4 and the center-tapped differential inductance L1 comprising two magnetically coupled inductances L1' and L1" with common center tap, has a differential input IN1, IN2 and an output resonating around the common mode node Vcom. The output of this first gain stage is capacitively coupled to a second amplifying or gain stage comprising the transistors M5' to M8' and the center-tapped differential inductance L2 comprising two magnetically coupled inductances L2' and L2" with common center tap. The output of the second gain stage resonates around the upper supply voltage Vsupply. The transistors M3, M4, M5' and M6' act as current buffers and are named in the following cascode transistors. As known, they allow higher input-output isolation, higher input and output impedances, and the reduction or elimination of the Miller effect and thus a higher bandwidth of the LNA.

Examples of the amplifier of Fig. 1 are described in the document "A 5.7 GHz 0.18 µm CMOS Gain-Controlled Differential LNA With Current Reuse for WLAN Receiver", Che-Hong Liao and Huey-Ru Chuang, IEEE Microwave and Wireless Components Letters, Vol. 13, No 12, December 2003 and in the document US20070176679.

The use of an active differential pair as input of the low noise amplifier has different drawbacks: first, the noise sources are doubled compared to the single-ended gain stage. Moreover it is often necessary to use some supplementary element, such as a balun, a single-differential SAW filter or any other passive transforming element.

Since a differential amplifier has two transconductance branches, it requires twice the DC current of a single-ended amplifier to generate the same overall transconductance. Since the input referred noise generated by the low noise amplifier itself is inversely proportional to the transconductance of the gain stages, equal noise power referred to the input requires a factor of two more current in the differential version to obtain the same noise performance as the single ended version.

The low noise amplifier having a differential input stage does not allow a direct connection to a single-ended antenna. Moreover the integrated circuit comprising such amplifier requires one more pin compared to a single-ended amplifier, and thus a supplementary RF port.

On the other hand, a differential amplifier or at least its differential output allows reduced problems in terms of common mode disturbances and linearity of the second order for the receiving chain.

It is an aim to the present invention to improve the current consumption, the gain and the noise performance of an amplifier, in particular of a two stages amplifier of a receiving chain.

Another aim of the present invention is to improve the current consumption of an amplifier by maintaining at least its output differential.

Another aim of the present invention is to avoid the use of external elements for performing the single to differential transformation.

If we consider again the amplifier of Fig. 1, we note also that the lower limit of its supply voltage is set by the required bias level of the upper cascode transistors M5, M6'. Furthermore, technological stress limits the maximum voltage swing of the output around the upper supply voltage Vsupply.

Another aim of the present invention is then to overcome the limitation of the maximum output voltage swing for a two stage stacked or current reuse low noise amplifier.

EP2037572 describes a two stage current reuse low noise amplifier comprising a first gain stage comprising a resonant load, a second gain stage connected to the first gain stage by a capacitive coupling via Cᵢₙₜ et C'ᵢₙₜ. The first gain stage comprises a first transistor M1 and a second transistor M3, which is coupled to the drain of the first transistor M1 by means of a capacitor Cdiff, which value is selected to copy the RF signal from one branch to the other one and at the same time block the DC current.

### Brief summary of the invention

According to the invention, these aims are achieved by means of a current reuse low noise amplifier according to the claim 1 and by means of an integrated circuit according to the claim 13.

The current reuse low noise amplifier according to the invention comprises a first gain stage with a resonant load and a second gain stage connected to the first gain stage by a capacitive coupling. Of course the capacitive coupling is an AC-capacitive coupling which allows a signal connection between the first and the second gain stage.

Advantageously the first gain stage is a single-ended stage, the second stage is a double-ended stage and the magnetic coupling within the resonant load of the first gain stage performs the single-ended to differential signal transformation between the first and the second gain stage.

The single-ended first stage allows a current reduction in the amplifier, while maintaining its performance in terms of the input referred noise: in fact the current required for a differential first stage is twice the current required for a single-ended first stage for the same input referred noise performance. Otherwise it allows a better performance in terms of noise and sensitivity at a constant current consumption compared to a differential first stage.

The single-ended first stage allows also a possible direct connection to a single-ended antenna, a reduction of the number of pin of the integrated circuit comprising this amplifier and a possible reduction of the size of its package.

The resonant load of the first gain stage advantageously can comprise a center-tapped differential inductance or in other words two magnetically coupled inductances with common center tap, one of them being connected to the first gain stage and carrying the DC current, the other generating the 180° phase-shifted differential signal and being an open circuit for DC currents. In other words the center-tapped differential inductance allows the coupling to the second gain working as a resonant auto-transformer with single-ended input and differential output.

In other words the center-tapped differential inductance is working as a resonant auto-transformer with single-ended input and differential output. The AC coupling between the two gain stages is done trough two coupling capacitances. The center-tapped differential inductance comprises two magnetically coupled inductances with a common center tap. The coupling coefficient between these two magnetically coupled inductances is greater than 0.5, preferably greater than 0.6, for example 0.7. In fact the harmonics due to amplitude mismatch (or in other words due to a coupling coefficient less than 1) are strongly suppressed due to the filtering effect of the resonance of the inductances.

In one embodiment the first gain stage of the low noise amplifier according to invention comprises a common source transistor and a common gate transistor in a cascode configuration. In a preferred embodiment these transistors are N-type CMOS or NMOS transistors.

The first gain stage can comprise one or more inductances to perform the impedance matching. In fact in general the LNA should have an input impedance which has to be constant and equal to the source impedance (usually 50 Ω)at the operating frequency, for optimizing the power transmission from the antenna to the low noise amplifier.

In another embodiment the first gain stage can be combined with the output of a power amplifier.

In another embodiment the common source transistor of the first gain stage can be inductively degenerated, in order to obtain the desired impedance matching by using resonant networks. The desired impedance in such a case is realized in a band of frequency narrower than other solutions.

In another embodiment the first gain stage comprises a current source and a common gate transistor.

In a preferred embodiment the second gain stage comprises a cascoded differential pair, i.e. it comprises two branches, each branch comprising two transistors in a cascoded configuration, and a resonant load.

Advantageously the transistors of the second gain stage can be P-type CMOS or PMOS transistors. In such a case the second gain stage comprises a center-tapped differential inductance as resonant load. This center-tapped differential inductance comprises two magnetically coupled inductances with a common center tap and it is directly above the center-tapped differential inductance of the first gain stage. In particular the common mode nodes of the center-tapped differential inductances of the first and the second gain stages can be connected together and biased at roughly half the supply voltage of the low noise amplifier. The output signal of the low noise amplifier is then fully symmetrised by the two consecutive differential resonances.

In this case the limitation of supply voltage for a two stage stacked differential amplifier is overcome since the oscillating output signal of the second amplifying stage is generated around a common mode voltage which is set to roughly half the supply voltage of the current reuse low noise amplifier. In this case the input to the second gain stage is referred to the supply voltage node while using PMOS transistors as transconductors. Cascode transistors, which can also be PMOS transistors, can be inserted for isolation between the input and the output of the second gain stage.

Since the DC-operating points of these transistors are referred to the supply voltage node, this arrangement of transistors allows for an adjustment of the operating point, which assures saturation of all transistors, even at low supply voltages. Advantageously the resonances of both amplifying stages oscillate around the same common mode at about half the supply voltage, thus avoiding technological stress of the output transistors of the two gain stages.

The low noise amplifier according to the invention is thus simple since its single-ended first stage allows a direct connection to a single-ended antenna possible. It either reduces the current consumption for the same noise performance or improves the noise performance at constant current consumption. It allows low supply-voltage operation due to the stacked gain stages. In one embodiment it reduces or avoids technological stress due to resonances at half the supply voltage.

According to another embodiment the second gain stage is a balanced frequency conversion mixer.

The invention concerns also an integrated circuit comprising the described current reuse low noise amplifier.

### Brief Description of the Drawings

The invention will be better understood with the aid of the description of an embodiment given by way of example and illustrated by the figures, in which:
Fig. 1 shows a view of a known current reuse low noise amplifier with a differential first gain stage.
Fig. 2 shows a view of a current reuse low noise amplifier with a differential first gain stage and a PMOS implementation of the second gain stage.
Fig. 3 shows an embodiment of a current reuse low noise amplifier according to the invention.
Figs. 4A to 4D show some possible configurations for the first gain stage of the current reuse low noise amplifier according to the invention.
Fig. 5 shows another embodiment of the current reuse low noise amplifier according to the invention, in which the second gain stage is a frequency conversion mixer.

### Detailed Description of possible embodiments of the Invention

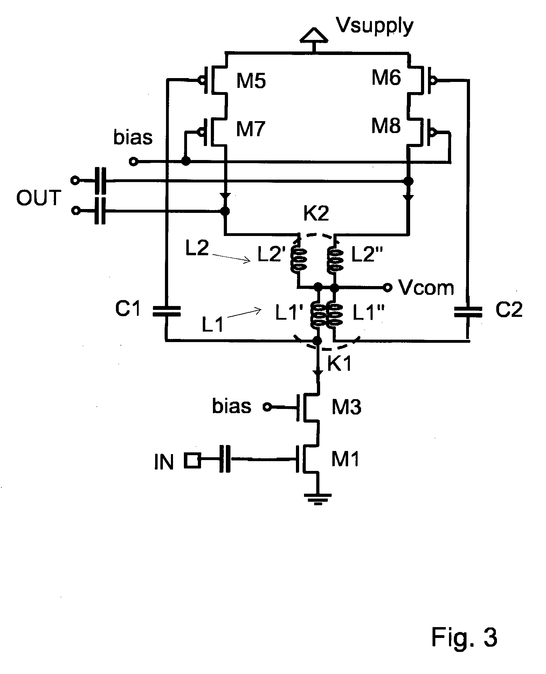

Fig. 3 shows an embodiment of a current reuse low noise amplifier according to the invention. Some bias circuits, for example the bias circuit of the second gain stage, are not illustrated for simplicity and clarity. This amplifier can be used for amplifying signals in the range of frequencies allowing an integration of the inductances L1 and/or L2 on a silicon slice. In a preferred embodiment the frequency of the signal belongs to the range 800 MHz - 6 GHz.

Each center-tapped differential inductance L1, L2 comprises two magnetically coupled inductances L1' and L1" respectively L2' and L2" with a common center tap. The coefficient of coupling between each pair L1'-L1" and L2'-L2" is named K1 respectively K2 in the Figures. K1 and K2 are superior to 0.5, preferably 0.7.

The current reuse low noise amplifier can be used for example and in a non limitative way in a GPS receiver (1.5 GHz) or in a receiver working in the industrial, scientific and medical (ISM) frequency band, for example at 2.4 GHz or 5.8 GHz.

The current reuse low noise amplifier of Fig. 3 comprises a first gain stage comprising the transistors M1 and M3, and a second gain stage comprising the transistors M5 to M7. In the illustrated embodiment the first gain stage comprises a common source transistor M1 and a common gate transistor M3 in a cascode configuration. In Fig. 3 these transistors are NMOS transistors, however they can be also PMOS transistors.

The second gain stage of. Fig. 3 comprises a cascoded differential pair, i.e. it comprises two branches, the left branch comprising the transistors M5 and M7 in a cascoded configuration, the right branch comprising the transistors M6 and M8 in a cascoded configuration.

Cascode transistors M7 and M8 are optional and can be inserted for isolation between the input and the output of the second gain stage.

The first gain stage is connected to the second gain stage by a capacitive coupling and the single-ended to differential signal transformation is performed by the resonant load of the first gain stage operating as a magnetically coupled auto-transformer.

The resonant load in the illustrated embodiment is the center-tapped differential inductance L1 acting as an auto-transformer with a single-ended input and a differential output. L1 comprises two magnetically coupled inductances L1', L1" with a common center tap at Vcom, L1' being connected to the first gain stage, in particular to the transistor M3 and carrying the DC current, L1" generating the 180° phase-shifted differential signal and being an open circuit for DC currents.

The inductance L1 is designed so that its coefficient of coupling K1 between L1' and L1" is greater than 0.5, preferably greater than 0.6, for example 0.7. In fact the harmonics due to amplitude mismatch are strongly suppressed by the filtering effect of the resonance of the inductance L1 with the capacitive load between the two signal ports of the differential inductance L1. The same considerations are valid for L2. In other words the integrated inductances L1, L2 are designed so as to resonate at the operating frequency due to their own capacitances and to a capacitive load, comprising for example the capacitance of parasitic capacitors to ground.

The signal is capacitively coupled to the second gain stage by capacitors C1 and C2.

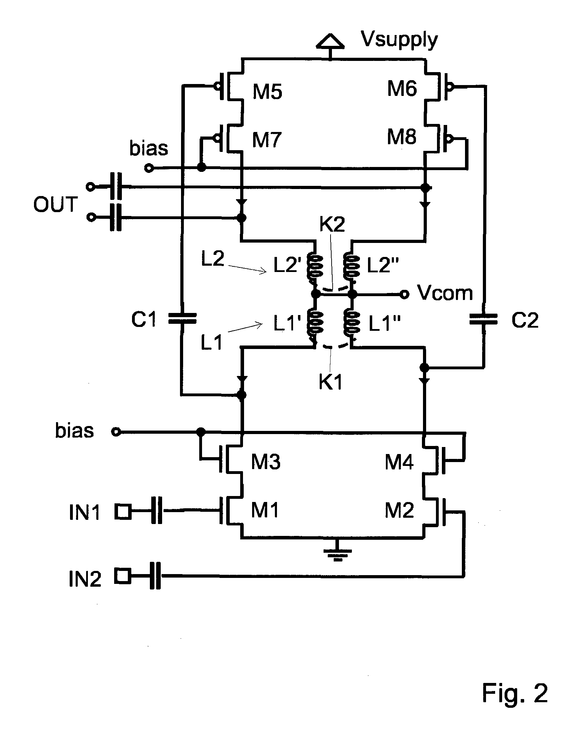

The single-ended first stage allows a current reduction in the amplifier, while maintaining its performance in terms of the input referred noise: in fact the current that would be required for a differential first stage, illustrated for example in Fig. 1 or 2, is twice the current required for a single-ended first stage for the same input referred noise performance as illustrated in Fig. 3. Otherwise the single-ended first stage allows a better performance in term of noise and gain at constant current consumption compared to a differential first stage.

Usually the single-ended first stage does not limit the linearity of the receiver since the following stages in the receiver chain experience much higher signal amplitudes due to the accumulated voltage gain.

The single-ended first stage allows also a direct connection to a single-ended antenna, the latter not being included in the figures, furthermore a reduction of the pin count of the integrated circuit comprising this amplifier and the possible reduction of the size of its package.

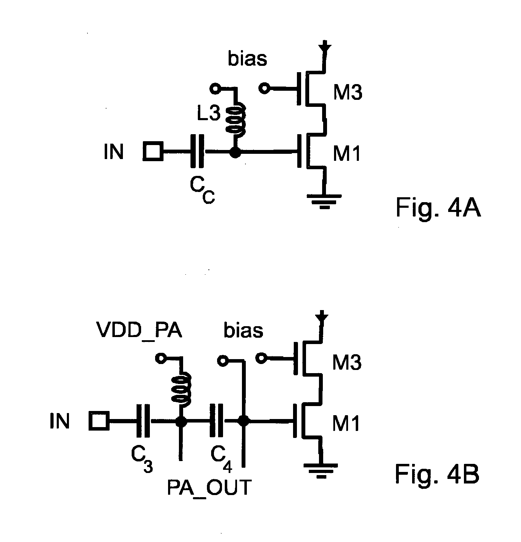

The first gain stage can comprise one or more inductances L3 for performing an impedance matching, as illustrated in Fig. 4A. In an example, the LNA has an input impedance which has to be constant and equal to 50 Ω within the frequency range of operation, for optimizing the power transmission from the antenna to the low noise amplifier. Other impedance value might be required for other antennas.

In another embodiment, illustrated in Fig. 4B, the first gain stage comprising the transistors M1 and M3 can be combined with the output of a power amplifier PA_OUT.

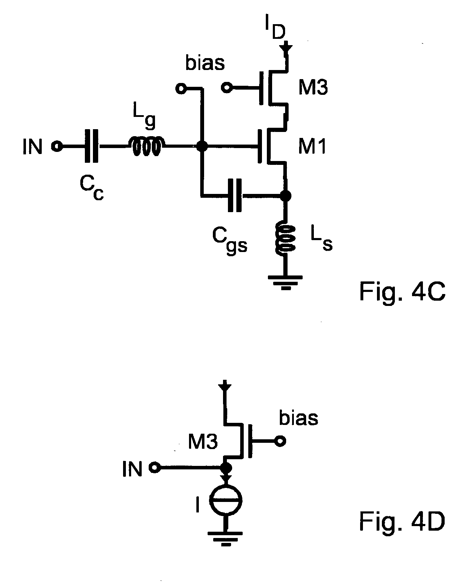

In another embodiment, illustrated in Fig. 4C, the common source transistor M1 of the first gain stage can be inductively degenerated, in order to obtain the desired impedance matching by using the resonant network formed by the inductances Ls and Lg respectively at the source and at the gate of the transistor M1 and the capacitor Cgs between its source and its gate. The desired impedance in such a case is realized in a band of frequency narrower than other solutions.

In another embodiment, illustrated in Fig. 4D, the first gain stage comprises a current source I and a common gate transistor M3.

According to an independent aspect of the invention, illustrated in Figs. 2 and 3, the transistors of the second gain stage (M5 - M8)can be PMOS transistors. In such a case the second gain stage comprises a center-tapped differential inductance L2, formed by two magnetically coupled inductances L2' and L2" as resonant load which is directly above the center-tapped differential inductance L1 of the first gain stage. In particular common mode nodes of the resonant networks L1 and L2 of the first and the second amplifier stage can be connected together and biased at roughly half the supply voltage.

In this case the limitation of supply voltage for a two stage stacked differential amplifier is overcome since the oscillating output signal of the second amplifying stage is generated around a common mode voltage Vcom which is set to roughly half the supply voltage Vsupply of the current reuse low noise amplifier. In this case the input to the second gain stage is referred to the supply voltage node while using PMOS transistors M5, M6 as transconductors.

Since the DC-operating points of these transistors are referred to the supply voltage node Vsupply, this arrangement of transistors M5 to M8 allows for an adjustment of the operating point, which assures saturation of all transistors, even at low supply voltages. Advantageously the resonances of both amplifying stages oscillate around the same common mode at about half the supply voltage, thus avoiding technological stress of the output transistors M3, M7 and M8 of the two gain stages. A bias circuit not illustrated adjusts the common mode voltage on node Vcom such that the linearity of the two-stage amplifier is optimized.

The use of two resonances L1 and L2 such that the common mode center taps of the inductances are connected together and biased at about half the supply voltage is not limited to a low noise amplifier having a single-ended input stage, but can be used also in a low noise amplifier having a differential input stage, as illustrated in Fig. 2.

On the other hand, the use of a single-ended input stage is not limited to the use of PMOS transistors in the second gain stage, which can be of course composed by NMOS transistors only.

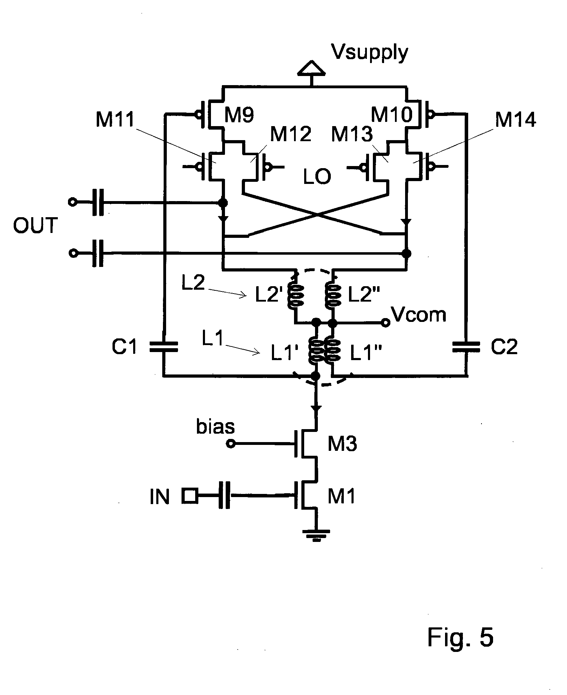

Advantageously the second gain stage can be implemented as balanced frequency conversion mixer, which is schematically shown in Figure 5. In the illustrated example the mixer function is realised by a Gilbert cell comprising PMOS transistors M9 to M14. NMOS transistors and/or other types of mixer can be used as well.

The described invention allows for example and in a non limitative way to design a LNA for a GPS receiver at 1.5 GHz which consumes 4 mA for a noise figure of 1.5 dB or a LNA for the ISM frequency band (2.4 GHz) which consumes 1.8 mA for a noise figure of 4dB. It is possible also to design a LNA for the ISM frequency band (2.4 GHz) with a current consumption reduced by about 30% compared to the known solutions and a better NF (4 dB instead of 5 dB). The given performance values depend of course on factors independent of the present invention, e.g. technological choice (technological node) and options (metallization), external matching, the realizations, etc.

## Claims

1. A two stage current reuse low noise amplifier comprising
- a first gain stage (M1, M3) comprising a resonant load (L1), said first gain stage (M1, M3) being a single-ended stage,
- a second gain stage (M5, M6, M7, M8) connected to said first gain stage (M1, M3) by a capacitive coupling (C1, C2), said second stage (M5, M6, M7, M8) being a double-ended stage
**characterised in that**
said resonant load (L1) comprises a single-ended input and a differential output performing the single-ended to differential signal transformation between said first and said second gain stage.

2. The two stage current reuse low noise amplifier according to claim 1, wherein said resonant load (L1) comprises two magnetically coupled inductances (L1', L1") with a common center tap (Vcom), one of them (L1') being connected to the first gain stage (M1, M3) and carrying the DC current, the other (L1") generating the 180° phase-shifted differential signal and being an open circuit for the DC current.

3. The two stage current reuse low noise amplifier according to one of claims 1 to 2, wherein the first gain stage comprises a common source transistor (M1) and a common gate transistor (M3).

4. The two stage current reuse low noise amplifier according to claim 3, wherein the input of the first gain stage comprises the output of a power amplifier (PA_out).

5. The two stage current reuse low noise amplifier according to one of claims 3 or 4, wherein the common source transistor (M1) of the first gain stage can be inductively degenerated.

6. The two stage current reuse low noise amplifier according to one of claims 1 or 5, wherein the first gain stage comprises a current source (I) and a common gate transistor (M3).

7. The two stage current reuse low noise amplifier according to one of claims 1 to 6, wherein the second gain stage comprises a cascoded differential pair (M5, M7; M6, M8), comprising two branches, each branch comprising two transistors in a cascoded configuration.

8. The two stage current reuse low noise amplifier according to the previous claim, wherein the cascoded differential pair (M5, M7; M6, M8) comprises at least two P-type CMOS transistors (M5, M6).

9. The two stage current reuse low noise amplifier according to the previous claim, wherein the second gain stage comprises a center-tapped differential inductance (L2) as a resonant load.

10. The two stage current reuse low noise amplifier according to one of claims 8 to 9, wherein the second gain stage is arranged so that the oscillating output signal of the second gain stage is generated around a common mode voltage (Vcom) which is set to roughly half the supply voltage (Vsupply) of the current reuse low noise amplifier.

11. The two stage current reuse low noise amplifier according to one of claims 9 to 10, wherein the common mode nodes (Vcom) of the center-tapped differential inductances (L1, L2) of the first and the second gain stage are arranged for being connected together and biased at roughly half the supply voltage (Vsupply) of the current reuse low noise amplifier.

12. The two stage current reuse low noise amplifier according to one of the claims 1 to 11, wherein the second gain stage is a balanced frequency conversion mixer.

13. An integrated circuit, comprising a two stage current reuse low noise amplifier according to one of the claims 1 to 12.

## Patentansprüche

1. Zweistufiger rauscharmer Verstärker mit Stromwiederverwendung, umfassend
- eine erste Verstärkungsstufe (M1, M3) mit einer schwingenden Last (L1), wobei die besagte erste Verstärkungsstufe (M1, M3) eine unsymmetrische Stufe ist,
- eine zweite Verstärkungsstufe (M5, M6, M7, M8), die durch eine kapazitive Verbindung (C1, C2) mit der besagten ersten Verstärkungsstufe (M1, M3) verbunden ist, wobei die zweite Verstärkungsstufe (M5, M6, M7, M8) eine Stufe mit differenziellem Ausgang ist,
**dadurch gekennzeichnet, dass**
die besagte schwingende Last (L1) einen unsymmetrischen Eingang und einen differenziellen Ausgang umfasst, welcher die unsymmetrisch-zu-differenziell Signalumwandlung zwischen der besagten ersten und zweiten Verstärkungsstufe ausführt.

2. Der zweistufige rauscharme Verstärker mit Stromwiederverwendung gemäss Anspruch 1, wobei die besagte schwingende Last (L1) zwei magnetisch miteinander gekoppelte induktive Widerstände (L1', L1 ") mit einem gemeinsamen Mittelabgriff (Vcom) umfasst, wobei einer dieser (L1') mit der ersten Verstärkungsstufe (M1, M3) verbunden ist und den Gleichstrom führt und der andere (L1 ") das um 180° phasenverschobene Differentialsignal erzeugt und eine offene Schaltung für den Gleichstrom bildet.

3. Der zweistufige rauscharme Verstärker mit Stromwiederverwendung gemäss einem der Ansprüche 1 bis 2, wobei die erste Verstärkungsstufe Transistor (M1) in Sourceschaltung und einen Transistor (M3) in Gateschaltung umfasst.

4. Der zweistufige rauscharme Verstärker mit Stromwiederverwendung gemäss Anspruch 3, wobei der Eingang der ersten Verstärkungsstufe den Ausgang eines Leistungsverstärkers (PA_out) umfasst.

5. Der zweistufige rauscharme Verstärker mit Stromwiederverwendung gemäss einem der Ansprüche 3 oder 4, wobei der Transistor (M1) in Sourceschaltung der ersten Verstärkungsstufe induktiv entartet sein kann.

6. Der zweistufige rauscharme Verstärker mit Stromwiederverwendung gemäss einem der Ansprüche 1 oder 5, wobei die erste Verstärkungsstufe eine Stromquelle (I) und einen Transistor (M3) mit Gatesteuerung umfasst.

7. Der zweistufige rauscharme Verstärker mit Stromwiederverwendung gemäss einem der Ansprüche 1 bis 6, wobei die zweite Verstärkungsstufe ein kaskodiertes Differential-Paar (M5, M7; M6, M8) mit zwei Zweigen umfasst, wobei jeder Zweig zwei Transistoren in einer Kaskodenkonfigurierung umfasst.

8. Der zweistufige rauscharme Verstärker mit Stromwiederverwendung gemäss dem vorhergehenden Anspruch, wobei das Kaskoden-Differential-Paar (M5, M7; M6, M8) mindestens zwei Typ-P CMOS-Transistoren (M5, M6) umfasst.

9. Der zweistufige rauscharme Verstärker mit Stromwiederverwendung gemäss dem vorhergehenden Anspruch, wobei die zweite Verstärkungsstufe einen zentral abgegriffenen differentiellen induktiven Widerstand (L2) als schwingende Last umfasst.

10. Der zweistufige rauscharme Verstärker mit Stromwiederverwendung gemäss einem der Ansprüche 8 bis 9, wobei die zweite Verstärkungsstufe so angeordnet ist, dass das schwingende Ausgangssignal der zweiten Verstärkungsstufe um eine Gleichtaktspannung (Vcom) erzeugt wird, die auf ungefähr die Hälfte der Speisespannung (Vsupply) des rauscharmen Verstärkers mit Stromwiederverwendung gesetzt ist.

11. Der zweistufige rauscharme Verstärker mit Stromwiederverwendung gemäss einem der Ansprüche 9 bis 10, wobei die Gleichtaktknoten (Vcom) der zentral abgegriffenen differentiellen induktiven Widerstände (L1, L2) der ersten und zweiten Verstärkungsstufe angeordnet sind, um zusammen verbunden zu werden und mit einer Versorgungsspannung von ungefähr der Hälfte der Speisespannung (Vsupply) des rauscharmen Verstärkers mit Stromwiederverwendung beaufschlagt werden.

12. Der zweistufige rauscharme Verstärker mit Stromwiederverwendung gemäss einem der Ansprüche 1 bis 11, wobei die zweite Verstärkungsstufe ein symmetrischer Frequenzumwandlungsmischer ist.

13. Eine integrierte Schaltung mit einem zweistufigen rauscharmen Verstärker mit Stromwiederverwendung gemäss einem der Ansprüche 1 bis 12.

## Revendications

1. Un amplificateur à faible bruit à réutilisation du courant à deux étages comprenant
- un premier étage de gain (M1, M3) comprenant une charge résonnante (L1), ledit premier étage de gain (M1, M3) étant un étage asymétrique,
- un deuxième étage de gain (M5, M6, M7, M8) relié audit premier étage de gain (M1, M3) par un accouplement capacitif (C1, C2), ledit deuxième étage (M5, M6, M7, M8) étant un étage double-sortie,
**caractérisé en ce que**
ladite charge résonnante (L1) comprend une entrée asymétrique et une sortie différentielle effectuant la conversion de signal d'asymétrique à différentiel entre ledit premier et ledit deuxième étage de gain.

2. L'amplificateur à faible bruit à réutilisation du courant à deux étages selon la revendication 1, dans lequel ladite charge résonnante (L1) comprend deux inductances (L1', L1") à couplage magnétique avec une prise centrale commune (Vcom), l'une des deux (L1') étant reliée au premier étage de gain (M1, M3) et transportant le courant continu, l'autre (L1") générant le signal différentiel déphasé de 180° et étant un circuit ouvert pour le courant continu.

3. L'amplificateur à faible bruit à réutilisation du courant à deux étages selon l'une des revendications 1 à 2, dans lequel le premier étage de gain comprend un transistor source commun (M1) et un transistor en grille commune (M3).

4. L'amplificateur à faible bruit à réutilisation du courant à deux étages selon la revendication 3, dans lequel l'entrée du premier étage de gain comprend la sortie d'un amplificateur de puissance (PA_out).

5. L'amplificateur à faible bruit à réutilisation du courant à deux étages selon l'une des revendications 3 ou 4, dans lequel le transistor source commun (M1) du premier étage de gain peut être à dégénération inductive.

6. L'amplificateur à faible bruit à réutilisation du courant à deux étages selon l'une des revendications 1 ou 5, dans lequel le premier étage de gain comprend une source de courant (I) et un transistor en grille commune (M3).

7. L'amplificateur à faible bruit à réutilisation du courant à deux étages selon l'une des revendications 1 à 6, dans lequel le deuxième étage de gain comprend une paire différentielle en cascode (M5, M7 ; M6, M8), comprenant deux branches, chaque branche comprenant deux transistors dans une configuration en cascode.

8. L'amplificateur à faible bruit à réutilisation du courant à deux étages selon la revendication précédente, dans lequel la paire différentielle en cascode (M5, M7 ; M6, M8) comprend au moins deux transistors CMOS de type P (M5, M6).

9. L'amplificateur à faible bruit à réutilisation du courant à deux étages selon la revendication précédente, dans lequel le deuxième étage de gain comprend une inductance différentielle à prise centrale (L2) comme charge résonnante.

10. L'amplificateur à faible bruit à réutilisation du courant à deux étages selon l'une des revendications 8 à 9, dans lequel le deuxième étage de gain est agencé de sorte que le signal de sortie oscillant du deuxième étage de gain est généré autour d'une tension en mode commun (Vcom) qui est fixée à environ la moitié de la tension d'alimentation (Vsupply) de l'amplificateur à faible bruit à réutilisation du courant.

11. L'amplificateur à faible bruit à réutilisation du courant à deux étages selon l'une des revendications 9 à 10, dans lequel les noeuds de mode commun (Vcom) des inductances différentielles à prise centrale (L1, L2) du premier et du deuxième étage de gain sont agencés pour être connectés ensemble et polarisés à environ la moitié de la tension d'alimentation (Vsupply) de l'amplificateur à faible bruit à réutilisation du courant.

12. L'amplificateur à faible bruit à réutilisation du courant à deux étages selon l'une des revendications 1 à 11, dans lequel le deuxième étage de gain est un mélangeur convertisseur de fréquence équilibrée.

13. Un circuit intégré, comprenant un amplificateur à faible bruit à réutilisation du courant à deux étages selon l'une des revendications 1 à 12.
